# EUROPÄISCHE PATENTANMELDUNG

(11) **EP 2 166 825 A1**
(43) Veröffentlichungstag der Anmeldung: **24.03.2010**
(21) Anmeldenummer: 08016390.0
(22) Anmeldetag: 17.09.2008
(51) Int. Cl.: H05K 1/14, H05K 3/36

(54) **Lötbares elektronisches Modul mit Schaltungsträger**

(71) Anmelder: Vincotech Holdings S.a.r.l., 2636 Luxembourg (LU)
(72) Erfinder: Koschnick, Frank, 82538 Geretsried (DE); Wiedemann, Hans, 87600 Kaufbeuren (DE); Frodl, Robert, 81825 München (DE)
(74) Vertreter: Grünecker, Kinkeldey, Stockmair & Schwanhäusser Anwaltssozietät

(57) **Zusammenfassung**

Die vorliegende Erfindung bezieht sich auf ein elektronisches Modul, das auf einem Trägerboard montiert werden kann. Weiterhin bezieht sich die vorliegende Erfindung auf ein Verfahren zum Herstellen eines solchen elektronischen Moduls sowie auf eine integrierte Schaltungsanordnung mit einem derartigen elektronischen Modul. Das Modul umfasst einen ersten Schaltungsträger (106), der auf einer ersten Oberfläche mindestens ein erstes elektronisches Bauelement (110) trägt, und der auf einer zweiten, der ersten Oberfläche gegenüberliegenden Oberfläche mindestens ein zweites elektronisches Bauelement (108) trägt. Erfindungsgemäß ist mindestens ein Kontaktstreifen (112) vorgesehen mit mindestens einer ersten Kontaktfläche, welche die zweite Oberfläche des ersten Schaltungsträgers elektrisch kontaktiert, und mit mindestens einer zweiten Kontaktfläche zum elektrischen Kontaktieren eines zweiten Schaltungsträgers, auf dem der erste Schaltungsträger montierbar ist, wobei der Kontaktstreifen mindestens eine Durchkontaktierung aufweist, die jeweils eine elektrische Verbindung zwischen der ersten und der zweiten Kontaktfläche herstellt.

## Beschreibung

Die vorliegende Erfindung bezieht sich auf ein elektronisches Modul mit einem ersten Schaltungsträger, der auf den beiden einander gegenüberliegenden Oberflächen jeweils mindestens ein elektronisches Bauelement trägt. Weiterhin bezieht sich die vorliegende Erfindung auf ein Verfahren zum Herstellen eines solchen elektronischen Moduls sowie auf eine integrierte Schaltungsanordnung mit einem derartigen elektronischen Modul.

Beim Montieren von beidseitig bestückten Schaltungsträgern wie beispielsweise Antennenmodulen für globale Navigationssatellitensysteme (GNSS), die auf einer Oberfläche des Schaltungsträgers ein Antennenelement und auf der entgegengesetzten Oberfläche integrierte Schaltungen tragen, sind verschiedene Konzepte zum mechanischen und elektrischen Verbinden eines solchen elektronischen Moduls mit einer weiteren Leiterplatte bekannt. Diese weitere Leiterplatte, die im Folgenden auch als Trägerboard oder zweiter Schaltungsträger bezeichnet wird, kann beispielsweise ein Motherboard einer übergeordneten Einheit, z. B. in einem Kraftfahrzeug, sein.

Es ist bekannt, ein elektronisches Modul wie beispielsweise ein Antennenmodul für ein globales Navigationssatellitensystem, beispielsweise GPS, auf einer Leiterplatte mittels Schrauben zu befestigen. In der Regel sind pro Modul vier Schrauben nötig, die von oben durch am Modul vorhandene Ösen gesteckt und von unten mit Beilagscheiben oder Bolzen und Muttern gesichert werden. Ein offensichtlicher Nachteil dieser Befestigungsmethode ist die Notwendigkeit, dass die Leiterplatte während des Montagevorgangs sowohl von der Ober- wie auch von der Unterseite her zugänglich sein muss. Weiterhin ist diese Montageart nur ungenügend automatisierbar.

Alternativ ist außerdem bekannt, Muttern auf der Leiterplattenunterseite vor der Montage fest mit der Leiterplatte zu verbinden, z.B. zu verkleben, und beispielsweise vormontierte Gewindebolzen auf der Leiterplatte vorzusehen. Jedoch besteht bei dieser Vorgehensweise das Problem, dass die Art der Montage umständlich ist und viele Einzelteile sowie Werkzeuge benötigt werden und eine Automatisierung ebenfalls schwierig ist.

Eine weitere Möglichkeit zur Befestigung von elektronischen Modulen, die zweiseitig bestückt sind, auf einer weiteren Leiterplatte, besteht im Aufschlagen von Anschlusskämmen, auf welche das Modul aufgesteckt wird. Ein Nachteil dieser Vorgehensweise besteht darin, dass die Leiterplatte mit den zu den Steckverbindern des jeweiligen Moduls passenden Gegensteckverbindern ausgestattet sein muss und daher vergleichsweise teuer wird.

Weiterhin haben bekannte Anordnungen meist den Nachteil, dass sie sowohl in der Fläche wie auch in der Horizontalen zu viel Platz benötigen.

Die Aufgabe, die der vorliegenden Erfindung zugrunde liegt, besteht daher darin, ein elektronisches Modul und ein zugehöriges Herstellungsverfahren anzugeben, das auf besonders kostengünstige, sichere und platzsparende Art und Weise auf einem weiteren Schaltungsträger montiert werden kann. Diese Aufgabe wird durch den Gegenstand der unabhängigen Patentansprüche gelöst. Vorteilhafte Weiterbildungen der vorliegenden Erfindung sind Gegenstand der abhängigen Patentansprüche.

Dabei basiert die vorliegende Erfindung auf der Idee, an dem ersten Schaltungsträger, der auf seiner ersten Oberfläche mindestens ein erstes elektronisches Bauelement trägt, und der auf seiner zweiten, der ersten Oberfläche gegenüberliegenden Oberfläche mindestens ein zweites elektronisches Bauelement trägt, mindestens einen Kontaktstreifen vorzusehen. Dieser Kontaktstreifen besitzt eine erste Kontaktfläche, welche die zweite Oberfläche des ersten Kontaktträgers elektrisch kontaktiert. Weiterhin besitzt der mindestens eine Kontaktstreifen mindestens eine zweite Kontaktfläche, um im vollständig montierten Zustand den zweiten Schaltungsträger, auf den der erste Schaltungsträger montiert werden soll, elektrisch zu kontaktieren.

Mit Hilfe einer solchen Anordnung können zweiseitig bestückte Leiterplatten als Surface Mount Device, SMD Modul verarbeitet werden.

Bei GNSS (Global Navigation Satellite System)-Antennenmodulen, die zweiseitig bestückt sind, war bisher mit mechanischen Halteelementen, beispielsweise Abstandshaltern und Schrauben, zur Befestigung sowie zusätzlichen Kabelverbindungen zu schaltbaren externen Antennen ein hoher Aufwand notwendig. Die Kabelverbindung hatte außerdem einen negativen Einfluss auf die Signalqualität. Insbesondere ließen sich diese Module nicht automatisch in einer SMT (Surface Mount Technology)-Linie, bestücken.

Demgegenüber bietet der erfindungsgemäße Aufbau entscheidende Vorteile. Ein zweiseitig bestücktes SMD-Modul mit Kontaktstreifen braucht etwa ein Drittel weniger Raum auf einer Leiterplatte, dadurch wird das Modul wesentlich kleiner als ein einseitig bestücktes Modul.

Die erfindungsgemäßen Kontaktstreifen können durch einen Bestückautomaten platziert werden und mit den restlichen Bauteilen im Reflow-Verfahren verlötet werden. Im Falle eines GNSS-Antennenmoduls oder GNSS-Antennenfrontend braucht man keine zusätzlichen Befestigungselemente oder Steckverbinder mehr und kann das erfindungsgemäße Modul automatisch als SMD montieren. Weiterhin wird die Signalqualität aufgrund des Wegfallens der Steckverbinder und Leitungen wesentlich verbessert.

Auf besonders kostengünstige und einfache Art und Weise können die erfindungsgemäßen Kontaktstreifen aus einem üblichen Leiterplattenmaterial (Printed Circuit Board, PCB), wie beispielsweise Epoxidharz, Glasfaser und Phenolpapier, aber auch Keramik hergestellt sein.

Gemäß einer vorteilhaften Weiterbildung der vorliegenden Erfindung hat der mindestens eine Kontaktstreifen eine rechteckförmige Grundfläche, was eine weitgehende Kompatibilität mit den üblicherweise rechteckförmigen Modulschaltungsträgern einerseits und eine kostengünstige Herstellbarkeit andererseits gewährleistet.

Eine mechanisch besonders stabile Anordnung erhält man, wenn an zwei einander gegenüberliegenden Randbereichen des ersten Schaltungsträgers jeweils ein Kontaktstreifen angeordnet ist. Für eventuelle Schirmungen kann aber auch eine Anordnung an vier Seiten vorteilhaft sein.

Für eine Montierbarkeit im Reflow-Lötverfahren ist es vorteilhaft, wenn die Durchkontaktierung durch halbe sogenannte Vias, die im Randbereich des Kontaktstreifens liegen, gebildet sind. Selbstverständlich können die Durchkontaktierungen aber auch im Innenbereich des Kontaktstreifens vorgesehen sein.

Für eine feste Verbindung sowohl zwischen dem Kontaktstreifen und dem Modulschaltungsträger wie auch zwischen dem Kontaktstreifen und dem zweiten Schaltungsträger können die Kontaktflächen der Kontaktstreifen lötbar ausgeführt sein.

Die vorteilhaften Eigenschaften des elektronischen Moduls gemäß der vorliegenden Erfindung kommen bei Anwendung in einem globalen Navigationssatellitensystem, GNSS, also einem System zur Positionsbestimmung und Navigation auf der Erde und in der Luft durch den Empfang von Satellitensignalen und Signalen von Pseudoliten, wie beispielsweise dem US-amerikanischen System GPS, besonders zum Tragen. Für eine derartige Anwendung kann auf der dem Kontaktstreifen abgewandten Oberfläche des Modulschaltungsträgers ein Antennenelement montiert sein. Dies kann beispielsweise eine Patchantenne oder eine Chipantenne sein, wie dies allgemein bekannt ist. Die Antenne kann aber auch in dem Schaltungsträger selbst integriert sein.

Allerdings ist für einen Fachmann klar, dass die erfindungsgemäße Art der Montage auch für andere auf einem Schaltungsträger montierte doppelseitig bestückte elektronische Module vorteilhaft ist.

Im Falle eines GNSS-Moduls werden die signalverarbeitenden Komponenten, wie Steuerung, Antennenfrontend-Bauteile und dergleichen, auf der selben Seite montiert wie die Kontaktstreifen, so dass sie in montiertem Zustand zwischen dem ersten und zweiten Schaltungsträger aufgenommen und so optimal geschützt sind.

Die erfindungsgemäße Anordnung des elektronischen Moduls erlaubt außerdem, eine externe Antenne als PCB-Designelement auf dem zweiten Schaltungsträger zu realisieren und unmittelbar über eine Lötverbindung mit dem Kontaktstreifen und über die Durchkontaktierungen mit den elektronischen Bauelementen zu verbinden. Der Einsatz von Kabeln oder Steckverbindern entfällt und die Signalqualität verbessert sich deutlich.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einige Merkmale oder Merkmalskombinationen aus den gezeigten und beschriebenen unterschiedlichen Ausführungsformen für sich eigenständige erfinderische oder erfindungsgemäße Lösungen darstellen. Es zeigen:
- Fig. 1: eine schematische Schnittdarstellung durch eine integrierte Schaltungsanordnung mit einem elektronischen Modul gemäß einer ersten Ausführungsform;
- Fig. 2: eine Ansicht von unten auf ein elektronisches Modul gemäß einer zweiten Ausführungsform;
- Fig. 3: eine Seitenansicht des Moduls aus Fig. 2 im montierten Zustand.

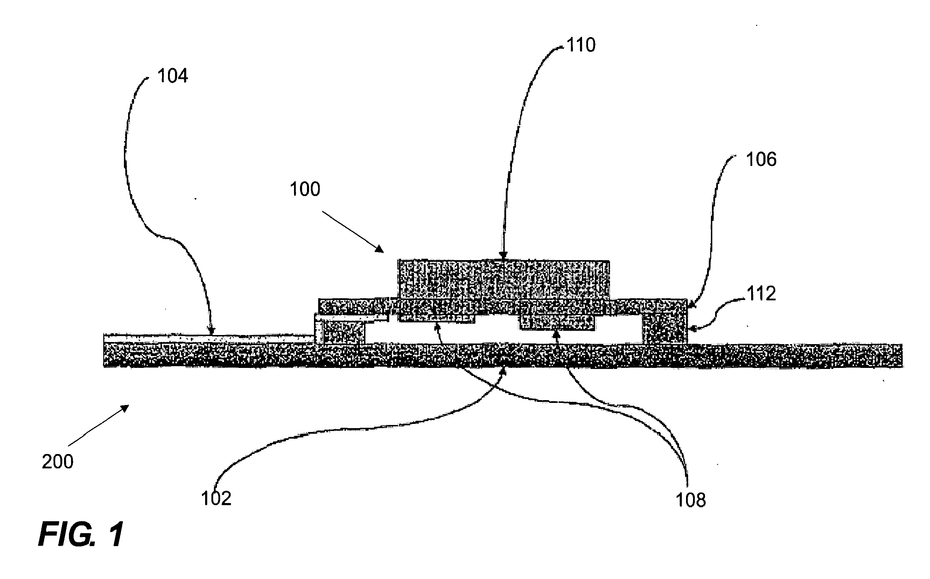

Fig. 1 zeigt eine schematische Schnittdarstellung einer integrierten Schaltungsanordnung 200, die ein erfindungsgemäßes elektronisches Modul 100 umfasst, das auf einer Leiterplatte, die auch Trägerboard 102 genannt wird, montiert ist.

Das Trägerboard 102 ist durch eine gedruckte Leiterplatte, PCB, Printed Circuit Board, wie dies allgemein bekannt ist, gebildet und kann beispielsweise eine externe Antenne (in der Figur nicht dargestellt) tragen. Die Zuleitungen zu der externen Antenne 104 können aufgrund der erfindungsgemäßen Aufbau- und Verbindungstechnik als PCB-Designelement ohne Steckverbinder und ohne Kabel realisiert werden.

Das erfindungsgemäße elektronische Modul ist in der gezeigten Anordnung beispielhaft ein Modul für ein globales Navigationssatellitensystem, GNSS, wie es beispielsweise in Kraftfahrzeugen zur Positionsbestimmung einsetzbar ist. Es ist aber für einen Fachmann klar, dass die erfindungsgemäßen Prinzipien auch für andere elektronische Module und deren Aufbau- und Verbindungstechnik anwendbar sind.

Auf einer Leiterplatte 106, die im Folgenden auch als erster Schaltungsträger oder Modulschaltungsträger bezeichnet wird, sind beidseitig elektronische Bauelemente 108 und 110 montiert. Dabei sind die dem Trägerboard 102 zugewandten Bauelemente 108 beispielsweise Antennenfrontend-Bauteile oder Signalverarbeitungs-ICs für GNSS-Anwendungen.

Auf der nach außen gerichteten Oberfläche des ersten Schaltungsträgers 106 ist in der gezeigten Ausführungsform ein Antennenelement 110 aufgebaut. Dies kann, wie es allgemein bekannt ist, eine Patchantenne oder eine Chipantenne sein. Die Leiterplatte 106 trägt, wie dies allgemein bekannt ist, durch Kontaktierungen und Leiterbahnstrukturen zum entsprechenden elektrischen Verbinden der elektronischen Bauelemente untereinander und mit dem Antennenelement bei. Weiterhin sind in einem Randbereich entsprechende Kontaktflecken vorgesehen, die erfindungsgemäß mit Kontaktstreifen 112 verlötet sind.

Dabei ist klar, dass das Wort Kontaktstreifen 112 zwar im vorliegenden Fall eine kleine Leiterplatte mit rechteckförmiger Grundfläche bezeichnet, dass aber selbstverständlich auch andere Formen, wie kreisförmige Kontaktelemente oder bogenförmige Strukturen denkbar sind. Erfindungsgemäß sind die Kontaktstreifen 112 auf der selben Seite des ersten Schaltungsträgers 106 montiert wie die integrierte Schaltung 108 und können während der Herstellung des elektronischen Moduls gleichzeitig mit diesen Bauelementen von einem Bestückautomaten positioniert und anschließend im Reflow-Verfahren mit dem ersten Schaltungsträger verlötet werden.

Üblicherweise wird das Antennenelement 110 als erstes auf der später dem Trägerboard 102 abgewandten Seite des ersten Schaltungsträgers 106 angebracht, bevor die Bauelementeseite, die im montierten Zustand dem Trägerboard 102 zugewandt ist, bestückt wird. Dies ist allerdings von der speziellen Ausführungsart der gewählten Antenne 110 abhängig. Für die Endmontage auf dem Trägerboard 102 muss nun nurmehr eine elektrische Verbindung zwischen der Unterseite der Kontaktstreifen 112 und entsprechenden Kontaktflecken auf dem Trägerboard 102 hergestellt werden. Dies kann wiederum von vollautomatisierten SMD-Bestückautomaten und einer anschließenden Reflow-Löttechnik unter Beachtung der entsprechenden Temperaturgrenze folgen.

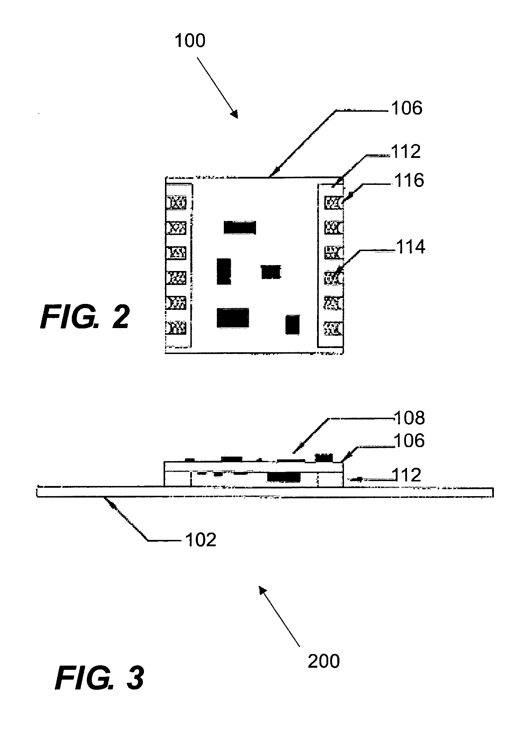

Die Figuren 2 und 3 zeigen in annähernd maßstäblicher Darstellung eine weitere Ausführungsform der integrierten Schaltungsanordnung 200. Dabei ist auf der dem Trägerboard 102 abgewandten Oberfläche des ersten Schaltungsträgers 106 eine Vielzahl von Bauelementen 108 montiert. Wie die Draufsicht auf die dem Trägerboard 102 zugewandte Oberfläche, die in Fig. 2 gezeigt ist, verdeutlicht, sind zwei Kontaktstreifen 112 mit im Wesentlichen rechteckförmiger Grundfläche an zwei Randbereichen des ersten Schaltungsträgers 106 angeordnet.

Diverse in dieser Figur nicht dargestellte Leiterbahnen stellen elektrische Verbindungen zwischen den Bauelementen 108 und den Kontaktflächen 114 her. Die elektrische Verbindung zu der gegenüberliegenden Seite der Kontaktstreifen 112, auf der ebenfalls korrespondierende Kontaktflächen angeordnet sind, geschieht durch Kontaktierungen 116. In der gezeigten Ausführungsform sind dies herkömmliche PCB-Vias, also Bohrungen, die an ihrer Innenfläche metallisiert sind, und die anschließend bei der Herstellung halbiert wurden. Dies kann durch in der Leiterplattentechnik übliche Verfahren wie Wasserstrahlschneiden, Laserschneiden oder dergleichen geschehen.

Diese Art der Herstellung der Durchkontaktierungen 116 hat den Vorteil, dass bei der Montage des elektronischen Moduls 100 auf dem Trägerboard 102 die Benetzung mit dem Lot in einfacher Weise gewährleistet werden kann und dass die Kontaktstreifen 112 besonders einfach herstellbar sind.

Mit Bezug auf die Fig. 1 bis 3 soll die Vorgehensweise bei der Montage der integrierten Schaltungsanordnung 200 nachfolgend im Detail beschrieben werden.

In einem ersten Schritt wird als vorgefertigtes Bauteil das elektronische Modul 100 hergestellt. Hierzu wird als Schaltungsträger eine mit entsprechend strukturierten Leiterbahnen versehene Leiterplatte 106 hergestellt. Anschließend wird diese Leiterplatte auf einer Seite mit den Bauelementen bestückt, die im endmontierten Zustand dem Trägerboard 102 abgewandt sind. Diese Bauelemente, die beispielsweise ein Antennenelement 110 umfassen können, werden z. B. mittels eines Reflow-Lötverfahrens elektrisch kontaktiert.

In einem nächsten Schritt wird die gegenüberliegende Oberfläche des ersten Schaltungsträgers 106 mit Bauelementen 108 und den Kontaktstreifen 112 bestückt und in einem Reflow-Verfahren angelötet. Dabei muss selbstverständlich darauf geachtet werden, dass die beim zweiten Lötschritt auftretenden Temperaturen die bereits montierten Bauelemente auf der gegenüberliegenden Seite nicht beschädigen oder in ihrer Position verschieben. Für die Montage der Kontaktstreifen 112 ist erfindungsgemäß kein zusätzlicher Arbeitsschritt notwendig. Die Kontaktstreifen 112 sind ebenfalls als herkömmliche Printed Circuit Board Streifen ausgeführt, die als Kontaktfläche elektrisch leitfähige Pads auf beiden Oberflächen haben, welche durch halbe Vias miteinander verbunden sind.

Das so hergestellte elektronische Modul 100 kann in Form von Bändern und Rollen oder als auf Trays verpackte Bauteile bevorratet werden. Für die endgültige Montage auf einem Trägerboard 102 wird das Modul 100, wie dies in der Surface Mount Technology, SMT, üblich ist, von einem Bestückautomaten auf entsprechenden Kontaktflecken des Trägerboards 102 positioniert und über einen dritten Lötschritt elektrisch kontaktiert. Das Trägerboard 102 kann dabei externe Antennenelemente, weitere elektronische Schaltungen und Leitungen umfassen.

In vorteilhafter Weise sind für die Montage keine komplizierten Verfahrensschritte und insbesondere keine separaten Steckverbinder und Kabel mehr erforderlich. Auf diese Weise kann die Endmontage des elektronischen Moduls 100 signifikant vereinfacht werden und gleichzeitig insbesondere bei Anwendung als ein Element eines globalen Navigationssatellitensystems die Signalqualität entscheidend verbessert werden.

### Bezugszeichenliste:

| **Bezugszeichen** | **Beschreibung** |
|---|---|
| 200 | Integrierte Schaltungsanordnung |
| 100 | Elektronisches Modul |
| 102 | Trägerboard (zweiter Schaltungsträger) |
| 104 | Verbindung zu einer externen Antenne |
| 106 | erster Schaltungsträger |
| 108 | elektronisches Bauelement |
| 110 | Antennenelement |
| 112 | Kontaktstreifen |
| 114 | Kontaktflächen |
| 116 | Durchkontaktierungen |

## Patentansprüche

1. Elektronisches Modul umfassend:
einen ersten Schaltungsträger (106), der auf einer ersten Oberfläche mindestens ein erstes elektronisches Bauelement (110) trägt, und der auf einer zweiten, der ersten Oberfläche gegenüberliegenden Oberfläche mindestens ein zweites elektronisches Bauelement (108) trägt,
mindestens einen Kontaktstreifen (112) mit mindestens einer ersten Kontaktfläche (114), welche die zweite Oberfläche des ersten Schaltungsträgers elektrisch kontaktiert, und mit mindestens einer zweiten Kontaktfläche (114) zum elektrischen Kontaktieren eines zweiten Schaltungsträgers, auf dem der erste Schaltungsträger montierbar ist,
wobei der Kontaktstreifen mindestens eine Durchkontaktierung (116) aufweist, die jeweils eine elektrische Verbindung zwischen der ersten und der zweiten Kontaktfläche herstellt.

2. Elektronisches Modul nach Anspruch 1, wobei der mindestens eine Kontaktstreifen (112) aus einem Leiterplattenmaterial hergestellt ist.

3. Elektronisches Modul nach Anspruch 1 oder 2, wobei der mindestens eine Kontaktstreifen (112) eine rechteckförmige Grundfläche hat.

4. Elektronisches Modul nach mindestens einem der vorhergehenden Ansprüche,
wobei zwei Kontaktstreifen (112) jeweils an einander gegenüberliegenden Randbereichen des ersten Schaltungsträgers (106) angeordnet sind.

5. Elektronisches Modul nach Anspruch 4, wobei die mindestens eine Durchkontaktierung (116) in einem äußeren Randbereich des Kontaktstreifens (112) angeordnet ist.

6. Elektronisches Modul nach mindestens einem der vorhergehenden Ansprüche,
wobei die elektrische Verbindung zwischen dem Kontaktstreifen (112) und dem ersten (106) und zweiten (102) Schaltungsträger jeweils eine Lötverbindung aufweist.

7. Elektronisches Modul nach mindestens einem der vorhergehenden Ansprüche,
wobei auf der dem Kontaktstreifen (112) abgewandten Oberfläche des ersten Schaltungsträgers (106) ein Antennenelement (110) montiert ist.

8. Elektronisches Modul nach mindestens einem der vorhergehenden Ansprüche,
wobei auf der dem Kontaktstreifen (112) zugewandten Oberfläche des ersten Schaltungsträgers (106) eine integrierte elektronische Schaltung (108) montiert ist.

9. Elektronisches Modul nach Anspruch 8, wobei die elektronische Schaltung (108) einen Empfänger für ein Globales Navigationssatellitensystem, GNSS, umfasst.

10. Integrierte Schaltungsanordnung umfassend ein elektronisches Modul (100) nach mindestens einem der vorhergehenden Ansprüche und den zweiten Schaltungsträger (102), auf dem das elektronische Modul montiert ist.

11. Integrierte Schaltungsanordnung nach Anspruch 10, wobei auf dem zweiten Schaltungsträger (102) ein Antennenelement montiert ist, das mit der mindestens einen zweiten Kontaktfläche des mindestens einen Kontaktstreifens (112) verbunden ist.

12. Verfahren zum Herstellen eines elektronischen Moduls mit den folgenden Schritten:
Montieren mindestens eines ersten elektronischen Bauelements auf einer ersten Oberfläche eines ersten Schaltungsträgers und Montieren mindestens eines zweiten elektronischen Bauelements auf einer zweiten, der ersten Oberfläche gegenüberliegenden Oberfläche des ersten Schaltungsträgers,
Montieren mindestens eines Kontaktstreifens mit mindestens einer ersten Kontaktfläche, welche die zweite Oberfläche des ersten Schaltungsträgers mit elektrisch kontaktiert, und mit mindestens einer zweiten Kontaktfläche zum elektrischen Kontaktieren eines zweiten Schaltungsträgers, auf dem der erste Schaltungsträger montierbar ist,
wobei der Kontaktstreifen Durchkontaktierungen aufweist, die eine elektrische Verbindung zwischen der ersten und der zweiten Kontaktfläche herstellen.

13. Verfahren zum Herstellen einer integrierten Schaltungsanordnung mit den folgenden Schritten:
Bereitstellen eines elektronischen Moduls mit dem Verfahren nach Anspruch 12,
Bestücken des zweiten Schaltungsträgers mit dem elektronischen Modul und Verlöten der mindestens einen zweiten Kontaktfläche mit entsprechenden Anschlüssen an dem zweiten Schaltungsträger.

14. Verfahren nach Anspruch 13, wobei der Schritt des Verlötens einen Reflowlötprozess umfasst.
